# EUROPEAN PATENT APPLICATION

(11) **EP 1 496 141 A1**
(43) Date of publication of application: **12.01.2005**
(21) Application number: 03015912.3
(22) Date of filing: 11.07.2003
(51) Int. Cl.: C23F 1/08, H05K 3/06

(54) **Transporting device for a vertical-type thin circuit board etching machine**

(71) Applicant: Kuo, Ming Hong, C/- Alfred Lei, Taipei (TW)
(72) Inventor: Kuo, Ming Hong, C/- Alfred Lei, Taipei (TW)
(74) Representative: Schmitt, Armand

(57) **Abstract**

A transporting device for a vertical-type thin circuit board etching machine which includes a base plate, a plurality of transporting units erected in linear formation and spaced apart on a base plate, a transmission shaft, characterized in that the transmission shaft passes through the other end of the frame connection of a plurality of transmission unit modules, and one end of the transmission shaft is connected to a power source and at the connection transmission unit, worm gears are formed, and for the transmission unit module includes transmission clip rollers, mounted in series to the shaft upward the base plate and mounted at the two lateral sides of the worm gears, a plurality of support rollers, a support roller frame driving gears, and the two driving gears are engaged with the corresponding worm gears, and the gap between two support roller faces of the support roller frames are stacked and the gap is the cleansing-etching thickness of the circuit board, and the base plate which corresponds to a circuit board portion is made of an etching resistant rigid material.

## Description

### BACKGROUND OF THE INVENTION

### (a) Technical Field of the Invention

The present invention relates to the field of a transporting device for a vertical-type thin circuit board etching machine. The circuit boards are transported in a vertical position and an etching solution is dropped onto the circuit board and the surface thereof will not accumulate etching solution, and hence the precision of etching of circuit boards is improved Further, a corrosion resistant hard seamless rail is used for supporting the weight of the circuit boards, which can transport a circuit board with a thickness of 0.05mm.

### (b) Description of the Prior Art

Owing to rapid development of electronic industries, more and more electronics have become smaller in size and provide multiple functions and so the copper-plated circuit panel of the mounted electronic components of the electronic product has to be etched with more precise circuit lines. Further, the thickness of the board must be thin.

However, the etching device for cleansing an etched circuit board generally has a horizontal transporting structure for transporting circuit boards in a horizontal direction. In the course of transporting, the electroplated copper surface of the circuit board is sprayed with an etching solution, and complete circuit lines will be etched after transportation. However, in the course of transporting, the cohesive force of the liquid molecules of the etching solution will cause accumulation of residual etching solution which moves horizontally on the circuit board. This will generate a "pond effect", preventing the corrosion and etching on the circuit board from being uniform. Thus, precise circuits cannot be etched Further, the two lateral bottom edges of the circuit board moving horizontally will cause the greater surface at the center of the board to become suspended, and the etching-cleansing process has to be performed based on the strength of the board body. Thus, the cleansing-etching of the thin circuit board cannot be performed effectively and the cleansing-etching fabrication is slow.

Accordingly, it is an object of the present invention to provide a transporting device for a vertical-type thin circuit board etching machine which can mitigate and obviate the above-mentioned drawbacks.

### SUMMARY OF THE INVENTION

Yet a main object of the present invention is to provide a transporting device for a vertical-type thin circuit board etching machine having a base plate, a plurality of transporting units erected in linear formation and spaced apart on a base plate, a transmission shaft, characterized in that the transmission shaft passes through the other end of the frame connection of a plurality of transmission unit modules, and one end of the transmission shaft is connected to a power source and at the connection transmission unit, worm gears are formed, and the transmission unit module includes transmission clip rollers, mounted in series to the shaft above the base plate and mounted at the two lateral sides of the worm gears, a plurality of support rollers, a support roller frame driving gears, and the two driving gear are engaged with the corresponding worm gears, and the gap between two support roller faces of the support roller frames are stacked and the gap is the cleansing-etching thickness of the circuit board, and the base plate which corresponds to the circuit board portion is made of an etching resistance rigid material.

Still another object of the present invention is to provide a transporting device for a vertical-type thin circuit board etching machine, wherein the support roller and transporting clip rollers are extended out from a shaft tube along the center line of the roller, and the center of the shaft tube is provided with a shaft hole and the tube opening of the two ends of the shaft tube is formed into an engaging slot allowing the stacked support wheels and the two engaging slots of the two stacked shaft tube to be mutually engaged to provide synchronized rotating of the wheels.

Yet another object of the present invention is to provide a transporting device for a vertical-type thin circuit board etching machine, wherein the material of the base plate corresponding with the circuit board is a flat board and a rail, on the flat plate along the circuit board pushing track a rail is secured, and the rail is a rail structure with a highly anti-corrosive chemical.

A further object of the present invention is to provide a transporting device for a vertical-type thin circuit board etching machine, in which the base plate includes a single plate formed into a flat plate and a rail.

The foregoing objects and summary provide only a brief introduction to the present invention. To fully appreciate these and other objects of the present invention as well as the invention itself, all of which will become apparent to those skilled in the art, the following detailed description of the invention and the claims should be read in conjunction with the accompanying drawings. Throughout the specification and drawings identical reference numerals refer to identical or similar parts.

Many other advantages and features of the present invention will become manifest to those versed in the art upon making reference to the detailed description and the accompanying sheets of drawings in which a preferred structural embodiment incorporating the principles of the present invention is shown by way of illustrative example.

### BRIEF DESCRIPTION OF THE DRAWINGS

FIG 1 is a perspective view of a transporting device for a vertical-type thin circuit board etching machine according to the present invention.
FIG 2 is a perspective exploded view of the present invention.
FIG 3 is a working view of the present invention.
FIG 4 is an enlarged side view showing the etching operation of a thin circuit board on the present invention.

### DETAILED DESCRIPTION OF THE PREFERRED EMBODIMENT

The following descriptions are of exemplary embodiments only, and are not intended to limit the scope, applicability or configuration of the invention in any way. Rather, the following description provides a convenient illustration for implementing exemplary embodiments of the invention. Various changes to the described embodiments may be made in the function and arrangement of the elements described without departing from the scope of the invention as set forth in the appended claims.

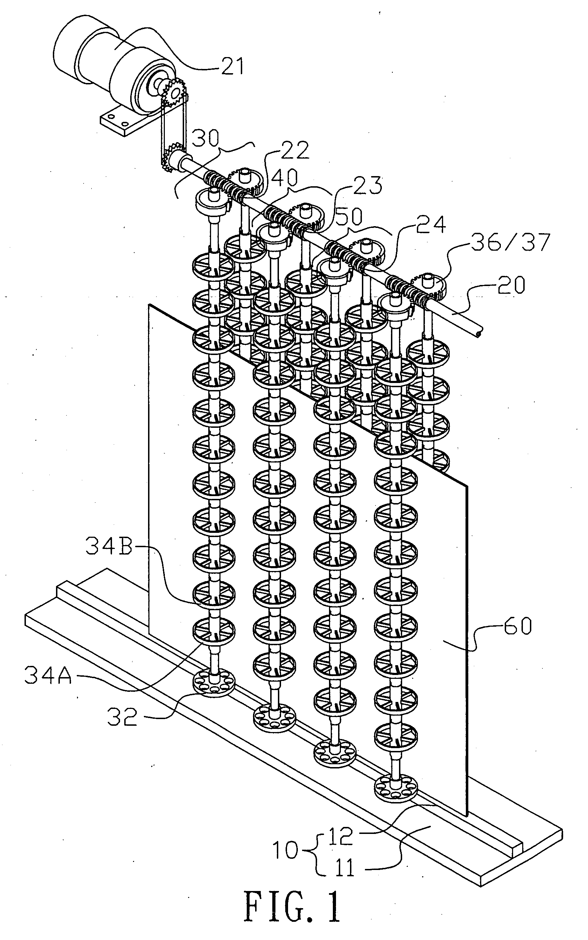

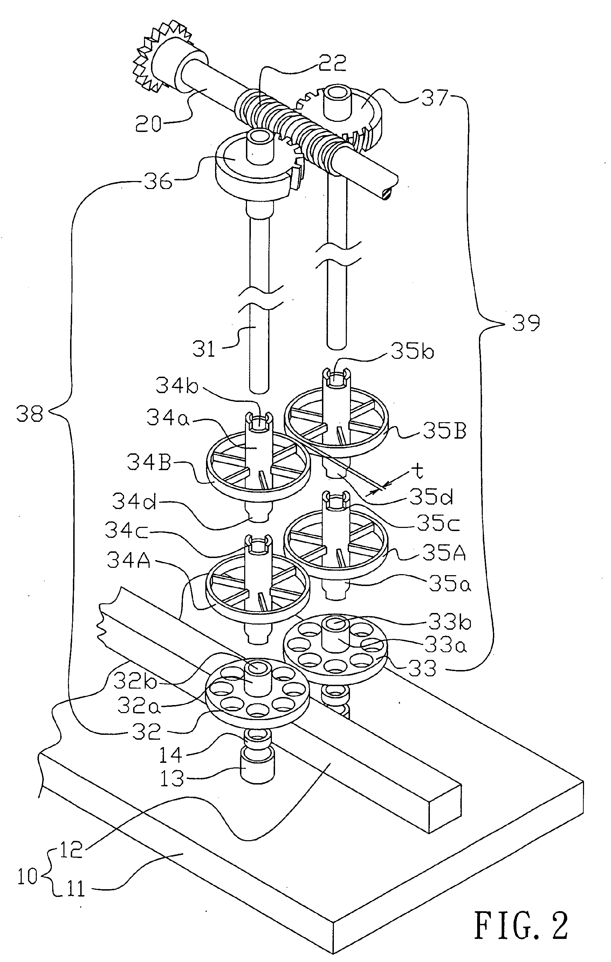

Referring to FIG 1, there is shown a perspective view of a transporting device for a vertical-type thin circuit board etching machine according to the present invention. FIG 2 is an exploded perspective view of a transporting device for a vertical-type thin circuit board etching machine according to the present invention. As shown in the figures, the transporting device includes a base plate 10, a transmission shaft 20, and a plurality of transmission units erected in linear formation and spaced apart on the base plate 10. The transmission shaft 20 passes through the other end of the base plate 10 supporting and connecting with the transmission unit modules 30, 40, 50 and one end of the transmission shaft 20 is connected to a power source such as electric motor 21 or combustion engine, and at places of the connection of the individual transmission unit modules 30, 40, 50, worm gears 22, 23, 24 are formed. All the transmission unit modules 30, 40, 50 are structurally the same. For clarity the transmission unit module 30 is used for explanation. The unit module 30 is located at the two sides of the worm gear 22, and from the base plate 10 moves upward to the through shaft 31 stacked onto a soft transmission clip rollers 32, 33, a plurality of support rollers 34A, 34B, 35A, 35B, a support roller frame 38, 39, of a worm gear 36,37. The two worm gears 36, 37 are engaged with the worm gear 22. The roller face gap between two support rollers 34A, 35A, 34B, 35B is the distance of the stacked height of the support roller frame 38, 39, which is the thickness and width of the cleansing-etching circuit board 60. The withheld circuit board 60 of the bottom plate 10 is an etching-resistance rigid material. As shown in the figure, the bottom plate 10 includes a flat plate 11 and a rail 12. On the flat plate 11, the plastic is pushed back along the circuit board 60. The rail 12 can be highly anti-corrosive plastic material such as glass or acid/alkali resistance plastic to form a seamless rail which can resist scratching at the edge of the circuit board, and is adhered to the surface of the flat plate 11 with an adhesive or by engagement. Practically, the base plate 10 is fabricated integrally into a flat plate 11 and a rail 12 by using a single block undergoing an engraving or injection molding process.

Thus, the plate face of the flat plate 11 will pass through the shaft end of a protruded shaft hole seat 13. Within the shaft hole, a bearing 14 of the shaft end has to mount only the corresponding shaft 31. As a result, the shaft end is fitted to individual shaft 13.

Further, the individual support rollers 34A, 34B, 35A, 35B, and the soft transporting clip rollers 32, 33 are integrally and vertically extended, along the center line of the rollers, from the shaft tube 32a, 33a, 34a, 35a, and the center of the shaft tubes 32a, 33a, 34a, and 35a are provided with shaft holes 32b, 33b, 34b, 35b for the shaft 31 to pass through and be firmly inserted After that the two end tube openings of the shaft tubes 34a, 35a of the individual support rollers 34A, 34B, 35A, 35B are formed into crown shaped engaging slots 34C, 35C, 34d, 35d. Any of the two stacked support rollers 34A, 34B or 35A, 35B are mutually engaged by the engaging slots 34C, 35C, 34d, 35d of the two stacked shaft tubes, such that with respect to transmission efficiency, all the rollers rotate synchronously, and the number of units of the support rollers 34A, 34B, 35A, 35B or the soft transporting clip rollers 32, 33 can be added or reduced, facilitating partial disassembly for maintenance, or for adjustment of the stacked height of the rollers along the shaft so as to match the height of different circuit boards, which allows all sizes of circuit boards to be transported Thus, in the course of maintenance or expansion, the structure of the present invention provides convenient assembly and flexible in application.

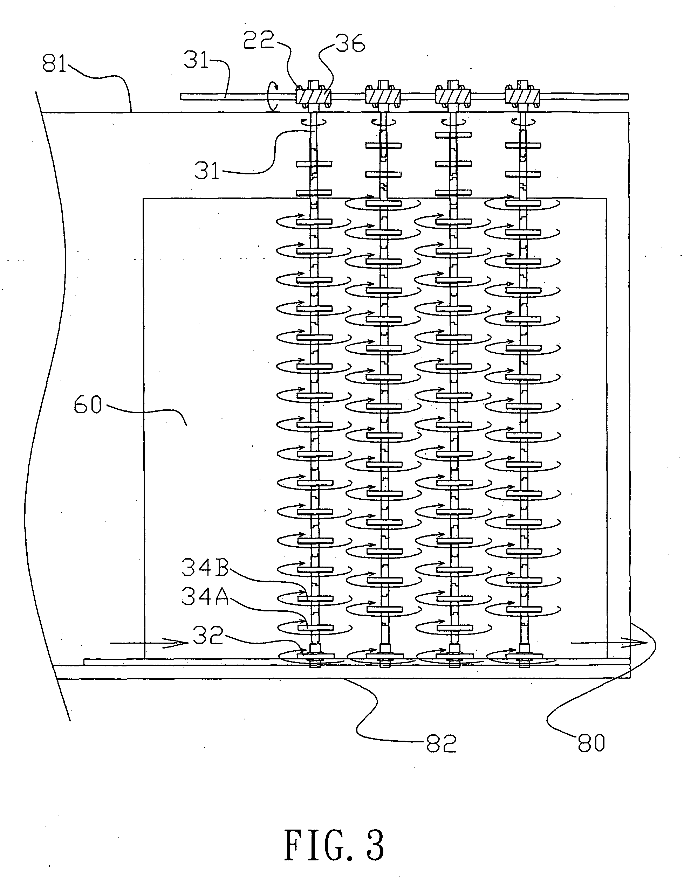

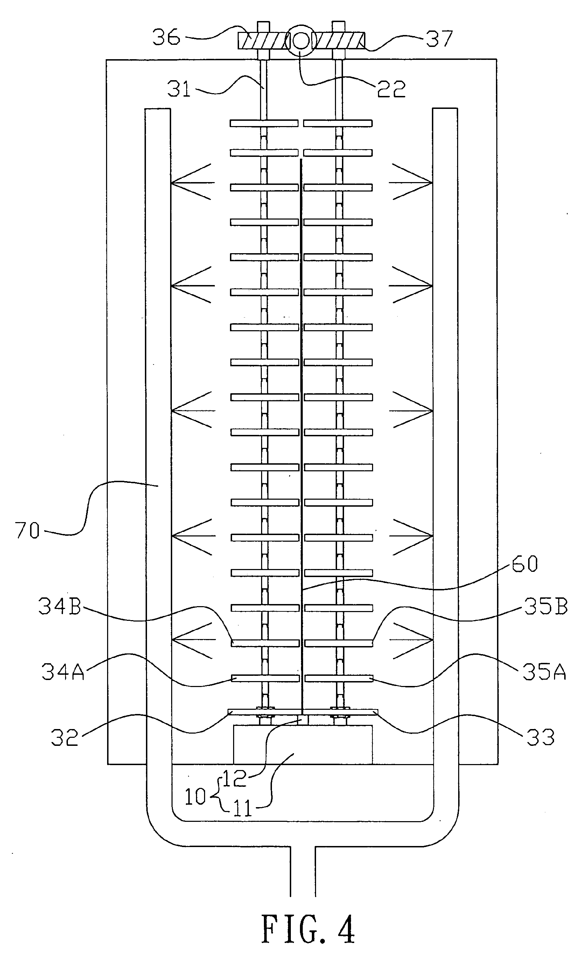

Referring to FIG 3, the entire transporting device or the components beneath the worm gears 36 can be placed in the delivery or discharging end and the device box 80 having an upper plate 81 and the bottom plate 82, to rotate the transmission shaft 20 by power. Thus, the individual support rollers 34A, 34B are rotated to move forward the circuit boards, as shown in FIG 4. The two lateral sides of the transmission apparatus are provided with conduits 70 for spraying of chemical agents.

Etching solution is sprayed around the transporting unit 30. The etching solution flows along the circuit boards and drops vertically without forming into solution pond.

It will be understood that each of the elements described above, or two or more together may also find a useful application in other types of methods differing from the type described above.

While certain novel features of this invention have been shown and described and are pointed out in the annexed claim, it is not intended to be limited to the details above, since it will be understood that various omissions, modifications, substitutions and changes in the forms and details of the device illustrated and in its operation can be made by those skilled in the art without departing in any way from the spirit of the present invention.

## Claims

1. A transporting device for a vertical-type thin circuit board etching machine comprising a base plate, a plurality of transporting units erected in linear formation and spaced apart on a base plate, and a transmission shaft, wherein the transmission shaft passes through the other end of the frame connection of a plurality of transmission unit modules, and one end of the transmission shaft is connected to a power source and at the connection transmission unit, worm gears are formed, and for the transmission unit module includes transmission clip rollers, mounted in series to the shaft upward the base plate and mounted at the two lateral sides of the worm gears, a plurality of support rollers, a support roller frame driving gears, and the two driving gear is engaged with the corresponding worm gears, and the gap between the two support roller faces of the support roller frames are stacked and the gap is the cleansing-etching thickness of the circuit board, and the base plate which corresponds to a circuit board portion is made of an etching resistance rigid material.

2. The transporting device of claim 1, wherein the support roller and transporting clip rollers are extended out from a shaft tube along the center line of the roller, and the center of the shaft tube is provided with a shaft hole and the tube opening of the two ends of the shaft tube is formed into an engaging slot allowing the stacked support wheels and the two engaging slots of the two stacked shaft tube are mutually engaged to provide synchronize rotating of the wheels.

3. The transporting device of claim 2, wherein the material of the base plate corresponding the withstand circuit board is a flat board and a rail, on the flat plate along the circuit board pushing track a rail is secured, and the rail is a rail structure with high anti-corrosive chemical.

4. The transporting device of claim 3, wherein the rail is a glass fiber body.

5. The transporting device of claim 3, wherein the rail is an anti-acid and alkali plastic body.

6. The transporting device of claim 3, wherein the base plate includes a single plate formed into a flat plate and the rail.

7. The transporting device of claim 3, wherein the board face of the flat plate is corresponding to a shaft end so as to mount a shaft hole seat, and the shaft hole seat is engaged with a bearing so that the shaft end will be secured to the flat surface of the shaft end mount of the individual shaft.
